# FASCICULE DE BREVET EUROPEEN

(11) **EP 2 118 671 B1**
(45) Date de publication et mention de la délivrance du brevet: **27.04.2011**
(21) Numéro de dépôt: 08775551.8
(22) Date de dépôt: 14.02.2008
(51) Int. Cl.: G01R 31/36, G01R 1/20, H01M 2/02, H01M 6/02

(54) **BOITIER DE DEPART D'UNE BATTERIE COMPORTANT UN SHUNT OU ELEMENT DE MESURE**
BATTERIEAUSGANGSLEISTUNGSGEHÄUSE MIT SHUNT ODER MESSELEMENT
BATTERY OUTPUT HOUSING COMPRISING A SHUNT OR MEASURING ELEMENT

(30) Priorité: 16.02.2007 FR 0701133
(43) Date de publication de la demande: 18.11.2009
(73) Titulaire: Valeo Etudes Electroniques, 94000 Créteil (FR)
(72) Inventeur: THIMON, Alain, F-93230 Romainville (FR); BOSNJAK, Joseph, F-78760 Jouars (FR)
(74) Mandataire: de Lambilly Delorme, Marie Pierre
(86) Numéro de dépôt international: PCT/FR2008/000185
(87) Numéro de publication internationale: WO 2008/129149

(56) Documents cités:
- FR-A1- 2 361 754
- US-B1- 6 316 914

## Description

La présente invention se rapporte à un assemblage formant boîtier dit de départ batterie, comportant notamment des fusibles et/ou des dispositifs de protection contre les courts-circuits et les décharges profondes en vue de la déconnexion de la batterie, sous la forme par exemple d'un commutateur de déconnexion ou coupure de batterie à came (PCS), ainsi qu'à un assemblage formant batterie comportant un assemblage formant boîtier de départ batterie de ce genre, notamment dans le domaine automobile.

Les dispositifs de l'art antérieur comportent une batterie ayant un pôle (+) et un pôle (-). Au pôle (+), est raccordé un boîtier de départ batterie qui comporte un ou des fusibles et un ou des éléments tels qu'un commutateur de coupure batterie ou un capteur magnétique de courant. Ces différents circuits ainsi qu'un éventuel circuit électronique de commande, qui dégagent de la chaleur, sont intégrés dans un boîtier que l'on essaye de rendre aussi peu volumineux que possible.

Au pôle (-) de la batterie, il est également connu de connecter un shunt de mesure, notamment sous la forme d'un barreau parallélépipédique, associé à un circuit électronique destiné à recevoir, mesurer et traiter les données issues du shunt de mesure, principalement le courant qui y passe. Ce circuit comporte également un capteur de la température de la batterie. Le shunt de mesure est d'une part branché au pôle (-) pour permettre le passage du courant entre ce potentiel et le potentiel se trouvant en amont du shunt de mesure et d'autre part se trouve dans un boîtier dédié ne comportant pas d'éléments dégageant de la chaleur, propre à modifier la mesure de la température par le capteur de température associé au shunt de mesure.

Ces dispositifs de l'art antérieur présentent ainsi l'inconvénient, dans le cas d'un dispositif comportant un capteur magnétique de courant, de ne pas être apte à effectuer ni des mesures de faibles courants (par exemple < 500mA), ni de forts courants (par exemple > 200A), et dans le cas d'un dispositif comportant un shunt de mesure, d'avoir à effectuer deux branchements sur le pôle(+) et le pôle(-) de deux bottiers distincts. En outre, il est nécessaire d'avoir à disposition, dans le stock en amont de la fabrication, deux boîtiers distincts, un boîtier pour le départ batterie et un boîtier pour le shunt de mesure. Enfin, les deux boîtiers dans leur ensemble sont volumineux et prennent beaucoup de place. FR 2 361 754 décrit un tel dispositif.

La présente invention vise à surmonter les inconvénients de l'art antérieur en proposant un nouveau système dans lequel l'ensemble des deux boîtiers et du ou des circuits qui se trouvent à l'intérieur prennent moins de place et s'installent plus rapidement sur la batterie, sans pour autant que la mesure du courant sur l'ensemble de la gamme allant des courants faibles aux courants forts et/ou de la température en soit affectée.

Suivant l'invention, un assemblage formant boîtier dit de départ batterie, destiné à être connecté au pôle positif de la batterie, comportant un boîtier à l'intérieur duquel est reçu au moins un élément supplémentaire tel qu'un fusible et/ou un commutateur; et une cosse destinée à la connexion à une borne de la batterie, caractérisé en ce qu'un shunt de mesure est reçu dans le boîtier en étant connecté entre la cosse et le ou les éléments supplémentaires, et il est prévu des moyens formant circuit électronique de réception, mesure et traitement du courant passant dans le shunt de mesure et ces moyens formant circuit électronique de réception, mesure et traitement comportent un amplificateur opérationnel dont les deux entrées e+ et e- sont connectées aux bornes du shunt de mesure, et des moyens étant prévus pour qu'une tension de mode commun d'une valeur correspondant au potentiel de la borne positive de la batterie soit acceptée par l'amplificateur.

Ainsi, en disposant l'ensemble des éléments dans le même boîtier et en le connectant à un seul pôle de la batterie, on obtient un système qui est moins volumineux que la somme des deux systèmes des dispositifs de l'art antérieur. Le shunt de mesure, contrairement à ce que l'on pouvait craindre, effectue des mesures aussi précises que s'il avait été connecté au pôle (-) de la batterie, comme dans l'art antérieur, et ce grâce au simple ajout d'un circuit électronique supplémentaire (un ampli opérationnel et un circuit décalage de mode commun) prenant peu de place et intégré au circuit associé au shunt de mesure.

De préférence, ces moyens d'acceptation sont constitués de moyens pour décaler les tensions d'alimentation de l'amplificateur opérationnel d'une valeur correspondant au potentiel de la borne positive de la batterie.

Suivant un mode de réalisation préféré, le circuit de décalage est constitué d'un circuit élévateur de tension, notamment une pompe de charge, monté dans le circuit de manière à décaler la tension d'alimentation de l'ampli opérationnel d'une valeur correspondant au potentiel de la borne positive de la batterie.

Suivant un mode de réalisation préféré, un circuit translateur de tension, translatant la tension d'une valeur correspondant à moins la valeur du potentiel de la borne positive de la batterie, est monté en aval de la sortie de l'amplificateur opérationnel.

On obtient ainsi que la tension inférieure d'alimentation de l'amplificateur opérationnel soit à un potentiel surélevé par rapport à la masse, des ou les autres composants étant à la masse, ce qui permet de diminuer la consommation globale du circuit.

Suivant un mode de réalisation préféré, les moyens formant circuit électronique de réception, mesure et traitement du courant passant dans le shunt de mesure comporte un capteur de la température.

Le capteur de température fonctionne aussi bien que dans le cas des dispositifs de l'art antérieur, dans lesquels il se trouvait dans un boîtier du côté du pôle négatif, et en particulier n'est pas sensible, comme on pouvait le craindre, au dégagement de chaleur par effet Joule des autres éléments (fusible, shunt, circuit électrique pour faire passer le courant, etc..).

Suivant un mode de réalisation préféré de l'invention, le circuit électronique de réception, traitement et mesure du courant passant dans le shunt de mesure comporte également un ou des circuits électroniques de commande des autres éléments et/ou fusible(s).

Suivant un mode de réalisation particulièrement avantageux, notamment permettant d'éviter une décharge de la batterie à l'arrêt, il est prévu un circuit comparateur de courant par rapport à un seuil prédéterminé destiné à réveiller le reste du circuit si le courant dépasse ledit seuil.

Suivant un mode de réalisation préféré, l'alimentation de l'électronique du shunt de mesure s'effectue suivant un mode en découpage temporel, le circuit électronique de mesure et de traitement comportant à cet effet de préférence une horloge ou un dispositif de cadencement.

Suivant un mode de réalisation préféré, le boîtier comporte un ou des fusibles et un commutateur de coupure, notamment à came dit PCS, et le shunt est disposé entre le commutateur et la cosse.

La présente invention se rapporte également à un assemblage formant batterie comportant une batterie ayant une borne positive et une borne négative; un boîtier de départ batterie comportant au moins un élément fonctionnel tel qu'un fusible et/ou un commutateur de coupure; une cosse destinée à se connecter à une borne de la batterie; et un shunt de mesure, caractérisé en ce que le shunt de mesure et son circuit électronique de réception, mesure et traitement du courant passant dans le shunt sont intégrés dans le boîtier de départ batterie, le circuit électronique de réception, mesure et traitement comportant un amplificateur opérationnel dont les deux entrées sont connectées aux bornes du shunt de mesure, des moyens étant prévus pour qu'une tension de mode commun d'une valeur correspondant au potentiel de la borne positive de la batterie soit acceptée par l'amplificateur.

La présente invention se rapporte également à un véhicule automobile comportant un assemblage suivant l'invention.

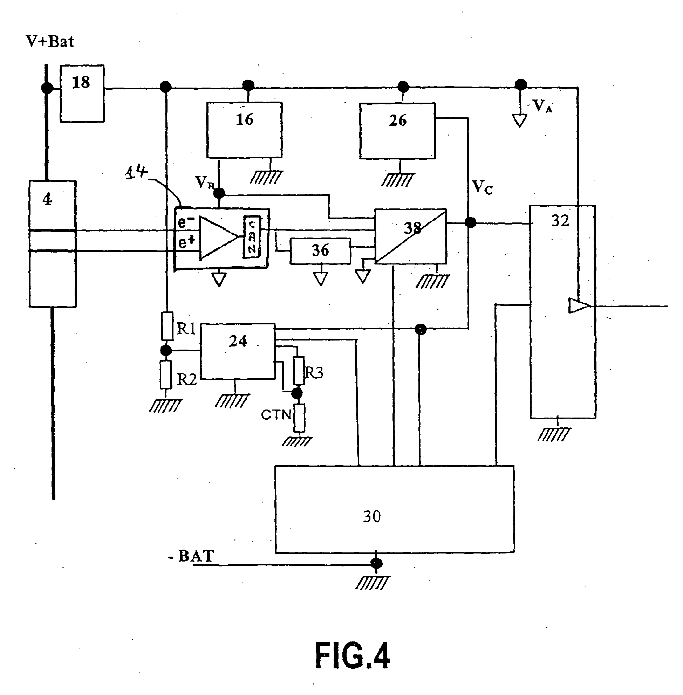

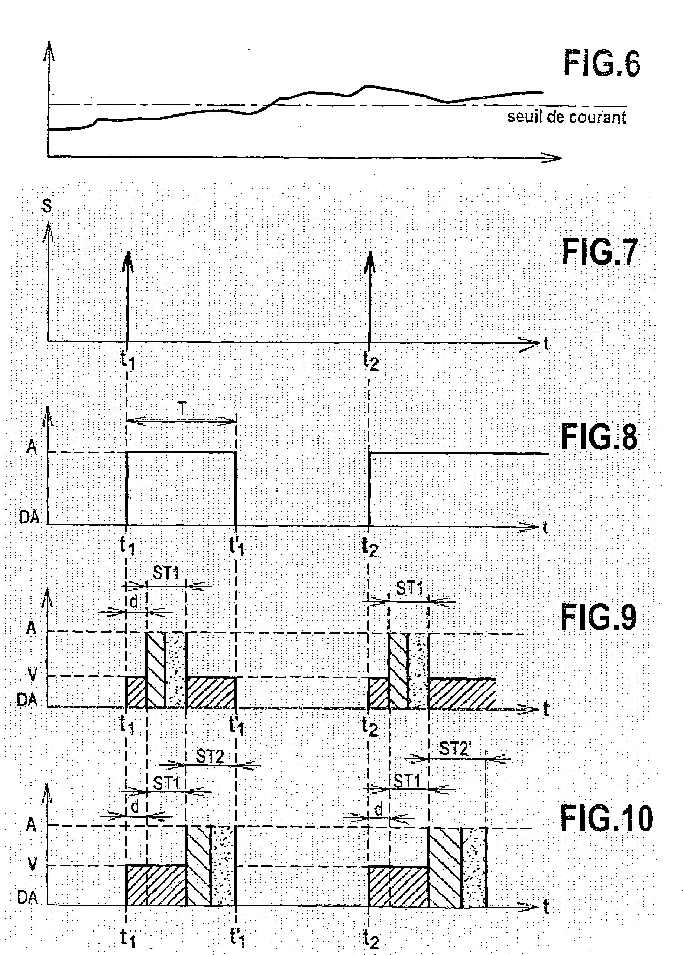

Aux dessins, donnés uniquement à titre d'exemple, il est représenté :
à la figure 1, une vue d'ensemble d'un assemblage de batterie suivant l'invention ;
à la figure 2, une vue plus en détail du shunt de mesure de la figure 1 ;

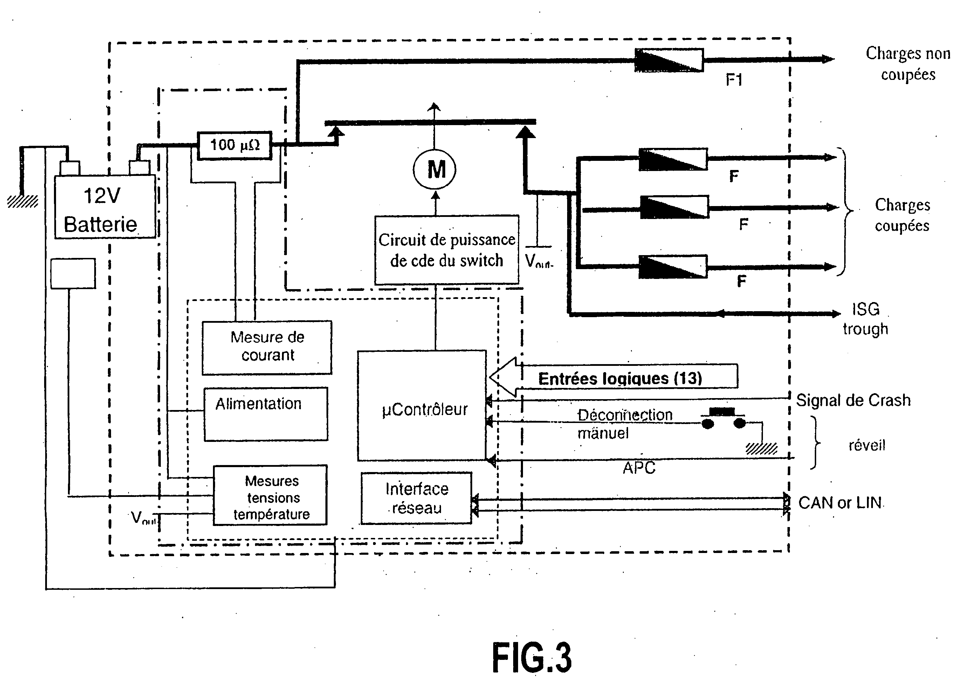

à la figure 3, un schéma bloc de principe du boîtier départ batterie de l'assemblage de la figure 1 ;
à la figure 4 un schéma fonctionnel d'un premier mode de réalisation du circuit électronique de réception, mesure et traitement couplé au shunt de mesure ;
à la figure 5 un schéma fonctionnel d'un second mode de réalisation du circuit électronique de réception, mesure et traitement couplé au shunt de mesure ; et
aux figures 6, 7, 8, 9 et 10 la variation au cours du temps des états des différents éléments des circuits électroniques de la figure 4, montrant la manière dont peut être gérée la consommation du courant en vue de limiter celle ci en phase veille du véhicule, la figure 6 représentant le profil de courant dans le shunt, la figure 7, l'horloge principale en phase veille du véhicule, la figure 8 le fonctionnement du circuit élévateur de tension, la figure 9 le fonctionnement du circuit convertisseur N/A et la figure 10 le fonctionnement du circuit de traitement.

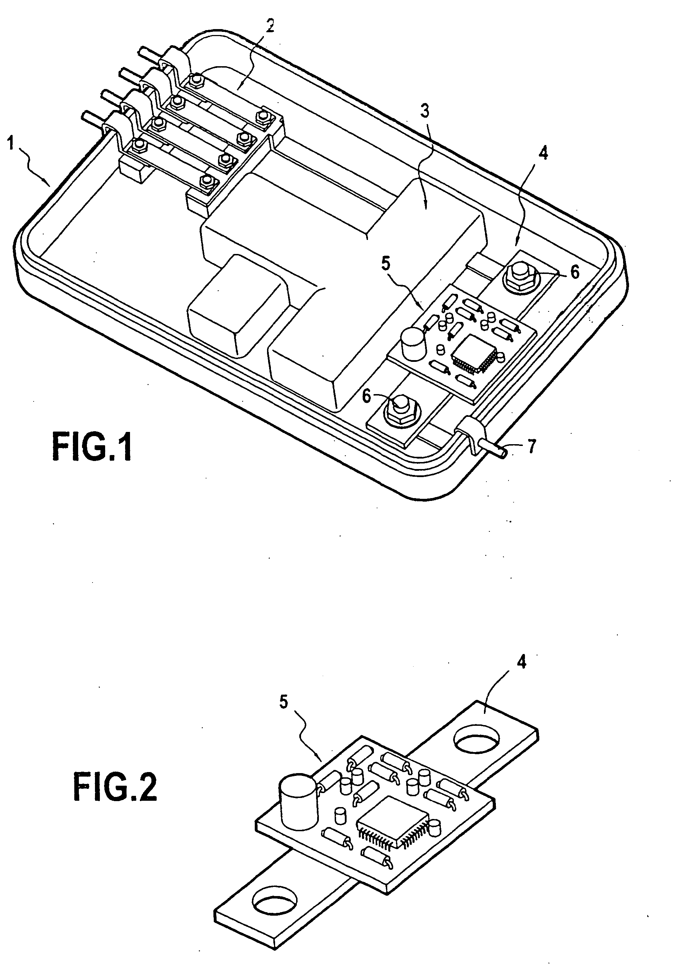

A la figure 1, une batterie (non représentée) comporte un pôle (+) et un pôle (-). Un boîtier 1 de départ batterie est connecté au pôle (+). Dans le boîtier 1 de départ batterie, se trouvent des fusibles 2, un commutateur à came 3 dit PCS, un shunt 4 de mesure sous la forme d'un barreau parallélépipédique dont les extrémités sont percées de trous pour sa connexion par des vis et écrous 6 à des bornes de connexion. Un circuit électronique 5 est couplé au shunt 4. Ce circuit comporte des éléments assurant que du courant passe dans le shunt de mesure, des éléments pour mesurer le courant qui passe dans le shunt et des éléments pour traiter ce courant mesuré en vue de déterminer un ou des paramètres de la batterie tel que l'état de charge de la batterie ou la température. Une cosse 7 fait saillie du boîtier pour venir se connecter à la borne + de la batterie.

Le commutateur à came est un commutateur classique à came entraîné par un moteur électrique et comportant un piston et une roue dentée entraînant alternativement le piston dans un sens (ouverture des contacts) ou dans l'autre (fermeture des contacts), la liaison cinématique entre le piston et la roue se faisant par une came, et le piston étant couplé à des contacts mobiles qui ainsi en fonction du mouvement du piston peuvent venir en contact avec des contacts fixes ou s'en éloigner. Ce commutateur permet de garantir que la batterie ne se décharge pas pendant les phases d'arrêts. Le shunt de mesure est relié entre la cosse 7, elle même connectée à la borne + de la batterie, et le commutateur PCS 3. Les fusibles 2 sont connectés au commutateur PCS du côté opposé au shunt de mesure. La borne + est à un potentiel Vbat, notamment égal à 12V.

Un premier mode de réalisation du circuit électronique 5 est représenté à la figure 4. Un module 14, comportant un amplificateur opérationnel et un convertisseur A/N, est monté aux bornes du shunt 4 de mesure. Ces deux entrées e+ et e- sont connectées respectivement de part et d'autre du shunt de mesure. La tension d'alimentation supérieure du module 14 est Vref , la tension d'alimentation inférieure étant 0V (la masse). Un circuit élévateur de tension sous la forme d'une pompe de charge 16 (ou circuit boost) est connecté à la borne positive de la batterie. Les deux tensions d'alimentation de l'amplificateur du module 14 sont ainsi décalées de VA, correspondant sensiblement au potentiel de la borne positive de la batterie. La tension d'alimentation inférieure de l'amplificateur a ainsi été décalée de 0V (la masse) à +VA, tandis que la tension d'alimentation supérieure de l'amplificateur a été décalée de Vref à Vref+VA.

Un circuit comparateur 36 est monté en aval de la sortie de l'amplificateur du module 14 et est également au potentiel VA. Enfin un circuit 38 décaleur de tension est monté en aval de l'amplificateur et sert à décaler la tension de sortie de l'amplificateur du module de nouveau d'une valeur -VA avant de l'envoyer vers le circuit 30 de traitement qui est référencé à la masse et non à VA. Ainsi le circuit translateur de tension 38 assure la communication entre les circuits 14 et 36 pour la détection du dépassement d'un seuil de courant et l'unité de traitement 30 référencée à la borne négative de la batterie (la masse).

Le circuit comporte également un capteur de la température CTN pour mesurer la température de la batterie. On peut prévoir un système logiciel dans le circuit électronique qui effectue une compensation de la mesure de la température pour tenir compte de l'influence sur celle ci des dégagements par effets Joule notamment des autres éléments dans le boîtier. Cependant, cette compensation n'est pas obligatoire, et il s'est avéré que la mesure de la température de la batterie n'est quasiment pas affectée par les autres éléments présents dans le boîtier, contrairement à ce que l'on aurait pu penser. Un filtre 18 d'entrée et un circuit 32 d'interface réseau complètent le dispositif.

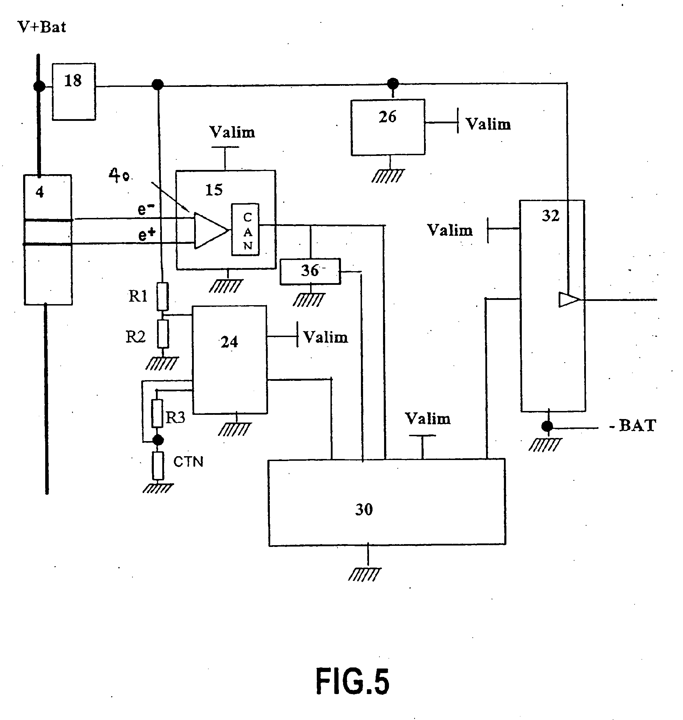

A la figure 5, il est représenté un schéma fonctionnel d'un deuxième mode de réalisation du circuit de réception, mesure et traitement. Ce circuit comporte un circuit 15 de lecture de la tension aux bornes du shunt qui comprend un amplificateur 40 différentiel monté de manière à accepter une tension de mode commun au moins égale à la tension de la batterie augmentée des tensions transitoires résultants des réseaux électriques du véhicule ou des perturbations extérieures. Le circuit est compléter par des éléments identiques à ceux du premier mode de réalisation et portants les mêmes références numériques, un filtre d'entrée 18, un régulateur de tension 26, un comparateur 36, une unité de traitement ou microcontrôleur 30, un circuit de mesure de la température et de la tension Vbat 24 et un circuit d'interface réseau 32. La tension d'alimentation de l'amplificateur opérationnel est décalée.

Le microcontrôleur 30 gère une basse fréquence (environ 1Hz) lorsque le véhicule est à l'arrêt. Les tops d'horloge sont représentés par t1 et t2 à la figure 7. A chaque impulsion d'horloge, l'élévateur de tension 16 est activé, comme on le voit à la figure 8. Pendant la phase T d'activation de l'élévateur de tension, les circuits 14, 36 et 38 sont alimentés. T se décompose en plusieurs intervalles de temps représentés aux figures 9 est 10. La durée T commence par une durée d de démarrage de l'élévateur de tension et de délivrance d'une tension d'alimentation suffisante aux autres circuits. Vient ensuite l'intervalle ST1 pendant lequel le circuit 14 est activé pour la mesure du courant dans le shunt. Ensuite pendant l'intervalle ST2, le circuit 14 est mis en veille et le comparateur 36 est activé afin de comparer le courant mesuré en ST1 avec un seuil prédéfini de courant. En cas de dépassement du seuil (cas de t2), le signal d'activation de l'élévateur de tension n'est pas remis à zéro et le microcontrôleur change de mode de fonctionnement pour vérifier que ce dépassement n'est que transitoire et ensuite pour déclencher les opérations adéquates, avant de repasser en mode veille. Dans le cas contraire (t1) le fonctionnement du circuit 16 est remis à zéro (en t'1).

La tension de mesure Vm issue d'un capteur est une tension différentielle entre deux conducteurs : Vm=V(e+) - V(e-).

On définit la tension de mode commun Vmc comme étant la tension commune à V(e+) et V(e-) et qui ne contient pas d'information. Ainsi, en posant Vmc=[V(e+)+V(e-)]/2, on obtient les tensions V(e+)= Vmc + Vm/2 et V(e-)=Vmc - Vm/2

De préférence, les moyens d'acceptations sont des moyens destiné à décaler la tension envoyée à l'entrée e- de l'amplificateur d'une valeur correspondant à moins la différence entre la valeur de la tension au potentiel positive de la batterie et la tension d'alimentation positive de l'amplificateur.

De préférence, l'amplificateur opérationnel est alimenté en courant pendant les phases de veille du véhicule tandis que d'autres composants du circuit ne le sont pas et il est prévu un circuit comparateur de courant par rapport à un seuil prédéterminé destiné à réveiller le reste du circuit si le courant dépasse ledit seuil, un circuit translateur de tension, translatant la tension d'une valeur correspondant à moins la valeur du potentiel de la borne positive de la batterie, étant monté en aval de la sortie de l'amplificateur opérationnel.

De préférence, seuls l'amplificateur opérationnel, le circuit translateur et un convertisseur A/N sont alimentés en courant pendant les phases de veille par le circuit élévateur de tension.

## Revendications

1. Assemblage formant boîtier dit de départ batterie, destiné à être connecté au pôle positif de la batterie, comportant un boîtier à l'intérieur duquel est reçu au moins un élément supplémentaire tel qu'un fusible et/ou un commutateur; et une cosse destinée à la connexion à une borne de la batterie, **caractérisé en ce qu'**un shunt de mesure est reçu dans le boîtier en étant connecté entre la cosse et le ou les éléments supplémentaires, et il est prévu des moyens formant circuit électronique de réception, mesure et traitement du courant passant dans le shunt de mesure et ces moyens formant circuit électronique de réception, mesure et traitement comportent un amplificateur opérationnel dont les deux entrées e+ et e- sont connectées aux bornes du shunt de mesure, et des moyens étant prévus pour qu'une tension de mode commun d'une valeur correspondant sensiblement au potentiel de la borne positive (Vbat) de la batterie soit acceptée par l'amplificateur.

2. Assemblage suivant la revendication 1, **caractérisé en ce que** les moyens d'acceptation sont constitués de moyens pour décaler les tensions d'alimentation de l'amplificateur opérationnel d'une valeur correspondant au potentiel de la borne positive de la batterie.

3. Assemblage suivant la revendication 2, **caractérisé en ce que** les moyens de décalage sont constitués d'un circuit élévateur de tension, notamment une pompe de charge, monté dans le circuit de manière à décaler la tension d'alimentation de l'ampli opérationnel d'une valeur correspondant au potentiel de la borne positive de la batterie.

4. Assemblage suivant la revendication 1, **caractérisé en ce que** les moyens d'acceptations sont des moyens destiné à décaler la tension envoyée à l'entrée e-de l'amplificateur d'une valeur correspondant à moins la différence entre la valeur de la tension au potentiel positive de la batterie et la tension d'alimentation positive de l'amplificateur.

5. Assemblage suivant l'une des revendications 1 à 4, **caractérisé en ce que** le circuit électronique de réception, mesure et traitement du courant passant dans le shunt de mesure comporte également un ou des circuits électroniques de commande du ou des éléments supplémentaires.

6. Assemblage suivant l'une des revendications 1 à 3 et 5, **caractérisé en ce que** l'amplificateur opérationnel est alimenté en courant pendant les phases de veille du véhicule tandis que d'autres composants du circuits ne le sont pas et il est prévu un circuit comparateur de courant par rapport à un seuil prédéterminé destiné à réveiller le reste du circuit si le courant dépasse ledit seuil, un circuit translateur de tension, translatant la tension d'une valeur correspondant à moins la valeur du potentiel de la borne positive de la batterie, étant monté en aval de la sortie de l'amplificateur opérationnel.

7. Assemblage suivant la revendication 6 dépendant de la revendication 3, **caractérisé en ce que** seuls l'amplificateur opérationnel, le circuit translateur et un convertisseur A/N sont alimentés en courant pendant les phases de veille par le circuit élévateur de tension.

8. Assemblage suivant l'une des revendications 1 à 7, **caractérisé en ce que** l'alimentation en courant du circuit de mesure s'effectue suivant un mode en découpage temporel, le circuit électronique de réception, mesure et traitement comportant à cet effet de préférence une horloge ou un dispositif de cadencement.

9. Assemblage suivant l'une des revendications 1 à 8, **caractérisé en ce que** le boîtier comporte un ou des fusibles et un commutateur, notamment à came dit PCS, et le shunt est disposé entre le commutateur et la cosse.

10. Assemblage formant batterie comportant une batterie ayant une borne positive et une borne négative; un boîtier de départ batterie comportant au moins un élément fonctionnel tel qu'un fusible et/ou un commutateur de coupure; une cosse destinée à se connecter à une borne de la batterie; et un shunt de mesure, **caractérisé en ce que** le shunt de mesure et son circuit électronique de réception, mesure et traitement du courant passant dans le shunt sont intégrés dans le boîtier de départ batterie, le circuit électronique de réception, mesure et traitement comportant un amplificateur opérationnel dont les deux entrées e+ et e-sont connectées aux bornes du shunt de mesure, des moyens étant prévus pour qu'une tension de mode commun d'une valeur correspondant au potentiel de la borne positive de la batterie soit acceptée par l'amplificateur.

11. Véhicule automobile comportant un assemblage suivant l'une des revendications précédentes.

## Claims

1. Assembly forming a housing called a battery output housing designed to be connected to the positive pole of the battery, comprising a housing inside which at least one additional element such as a fuse and/or a switch is received; and a cable terminal designed for the connection to a battery terminal, **characterized in that** a measuring shunt is received in the housing while being connected between the cable terminal and the additional element or elements, and means are provided forming an electronic circuit for receiving, measuring and processing the current entering the measuring shunt and these means forming an electronic circuit for receiving, measuring and processing comprise an operational amplifier the two inputs of which e+ and e- are connected to the terminals of the measuring shunt, and means being provided so that a common-mode voltage with a value corresponding substantially to the potential of the positive terminal (Vbat) of the battery is accepted by the amplifier.

2. Assembly according to Claim 1, **characterized in that** the acceptance means consist of means for shifting the power supply voltages of the operational amplifier by a value corresponding to the potential of the positive terminal of the battery.

3. Assembly according to Claim 2, **characterized in that** the shifting means consist of a voltage-raising circuit, notably a charge pump converter, mounted in the circuit so as to shift the power supply voltage of the operational amplifier by a value corresponding to the potential of the positive terminal of the battery.

4. Assembly according to Claim 1, **characterized in that** the acceptance means are means designed to shift the voltage sent to the input e- of the amplifier by a value corresponding to at least the difference between the value of the voltage at the positive potential of the battery and the positive power supply voltage of the amplifier.

5. Assembly according to one of Claims 1 to 4, **characterized in that** the electronic circuit for receiving, measuring and processing the current entering the measuring shunt also comprises one or more electronic circuits for controlling the additional element or elements.

6. Assembly according to one of Claims 1 to 3 and 5, **characterized in that** the operational amplifier is supplied with current during the standby phases of the vehicle while other components of the circuits are not, and a circuit is provided that is a comparator of current relative to a predetermined threshold designed to reactivate the rest of the circuit if the current exceeds the said threshold, a voltage-converting circuit, converting the voltage by a value corresponding to at least the value of the potential of the positive terminal of the battery, being mounted downstream of the output of the operational amplifier.

7. Assembly according to Claim 6 dependent on Claim 3, **characterized in that** only the operational amplifier, the converter circuit and an A/D converter are supplied with current during the standby phases by the voltage-raising circuit.

8. Assembly according to one of Claims 1 to 7, **characterized in that** the supplying with current of the measuring circuit is carried out according to a time-chopping mode, the electronic circuit for receiving, measuring and processing comprising for this purpose preferably a clock or a timing device.

9. Assembly according to one of Claims 1 to 8, **characterized in that** the housing comprises one or more fuses and a switch, notably with a PCS cam, and the shunt is placed between the switch and the cable terminal.

10. Assembly forming a battery comprising a battery having a positive terminal and a negative terminal; a battery output housing comprising at least one functional element such as a fuse and/or a chopping switch; a cable terminal designed to be connected to a battery terminal; and a measuring shunt, **characterized in that** the measuring shunt and its electronic circuit for receiving, measuring and processing the current entering the shunt are incorporated into the battery output housing, the electronic circuit for receiving, measuring and processing comprising an operational amplifier the two inputs of which e+ and e- are connected to the terminals of the measuring shunt, means being provided so that a common mode voltage with a value corresponding to the potential of the positive terminal of the battery is accepted by the amplifier.

11. Motor vehicle comprising an assembly according to one of the preceding claims.

## Patentansprüche

1. Zusammenbau, der ein so genanntes Batterie-Abgangsgehäuse bildet, das dazu bestimmt ist, mit dem positiven Pol der Batterie verbunden zu werden, mit einem Gehäuse, in dessen Innerem mindestens ein zusätzliches Element wie eine Sicherung und/oder ein Schalter aufgenommen wird, und mit einem Kabelschuh, der zur Verbindung mit einer Klemme der Batterie bestimmt ist, **dadurch gekennzeichnet, dass** ein Mess-Shunt im Gehäuse aufgenommen wird, indem er zwischen dem Kabelschuh und dem oder den zusätzlichen Elementen angeschlossen wird, und Einrichtungen vorgesehen sind, die eine Elektronikschaltung für den Empfang, die Messung und die Verarbeitung des durch den Mess-Shunt fließenden Stroms bilden, und diese eine Elektronikschaltung für den Empfang, die Messung und die Verarbeitung bildenden Einrichtungen einen Operationsverstärker aufweisen, dessen zwei Eingänge e+ und e- an die Klemmen des Mess-Shunts angeschlossen sind, und wobei Einrichtungen vorgesehen sind, damit eine Gleichtaktspannung eines Werts, der im Wesentlichen dem Potential der positiven Klemme (Vbat) der Batterie entspricht, vom Verstärker angenommen wird.

2. Zusammenbau nach Anspruch 1, **dadurch gekennzeichnet, dass** die Annahmeeinrichtungen aus Einrichtungen bestehen, um die Speisespannungen des Operationsverstärkers um einen Wert zu verschieben, der dem Potential der positiven Klemme der Batterie entspricht.

3. Zusammenbau nach Anspruch 2, **dadurch gekennzeichnet, dass** die Verschiebeeinrichtungen aus einer Aufwärtsschaltung, insbesondere einer Ladungspumpe, bestehen, die so in die Schaltung eingebaut ist, dass sie die Speisespannung des Operationsverstärkers um einen Wert verschiebt, der dem Potential der positiven Klemme der Batterie entspricht.

4. Zusammenbau nach Anspruch 1, **dadurch gekennzeichnet, dass** die Annahmeeinrichtungen Einrichtungen sind, die dazu bestimmt sind, die an den Eingang e- des Verstärkers geschickte Spannung um einen Wert zu verschieben, der mindestens der Differenz zwischen dem Wert der Spannung am positiven Potential der Batterie und der positiven Speisespannung des Verstärkers entspricht.

5. Zusammenbau nach einem der Ansprüche 1 bis 4, **dadurch gekennzeichnet, dass** die Elektronikschaltung für den Empfang, die Messung und die Verarbeitung des durch den Mess-Shunt fließenden Stroms ebenfalls eine oder mehrere Elektronikschaltungen zur Steuerung des oder der zusätzlichen Elemente aufweist.

6. Zusammenbau nach einem der Ansprüche 1 bis 3 und 5, **dadurch gekennzeichnet, dass** der Operationsverstärker während der Bereitschaftsphasen des Fahrzeugs mit Strom gespeist wird, während andere Bauteile der Schaltung es nicht sind, und eine Stromvergleichsschaltung bezüglich eines vorbestimmten Schwellwerts vorgesehen ist, die dazu bestimmt ist, den Rest der Schaltung einzuschalten, wenn der Strom den Schwellwert überschreitet, wobei eine Spannungsverlagerungsschaltung, die die Spannung um einen Wert verlagert, der mindestens dem Wert des Potentials der positiven Klemme der Batterie entspricht, hinter den Ausgang des Operationsverstärkers montiert ist.

7. Zusammenbau nach Anspruch 6 abhängig von Anspruch 3, **dadurch gekennzeichnet, dass** nur der Operationsverstärker, die Verlagerungsschaltung und ein A/D-Wandler während der Bereitschaftsphasen von der Aufwärtsschaltung mit Strom gespeist werden.

8. Zusammenbau nach einem der Ansprüche 1 bis 7, **dadurch gekennzeichnet, dass** die Stromspeisung der Messschaltung gemäß einer Zeitscheiben-Betriebsart erfolgt, wobei die Elektronikschaltung für den Empfang, die Messung und die Verarbeitung zu diesem Zweck vorzugsweise einen Taktgeber oder eine Taktgebungsvorrichtung aufweist.

9. Zusammenbau nach einem der Ansprüche 1 bis 8, **dadurch gekennzeichnet, dass** das Gehäuse eine oder mehrere Sicherungen und einen Schalter, insbesondere einen Nockenschalter, PCS genannt, aufweist, und der Shunt zwischen dem Schalter und dem Kabelschuh angeordnet ist.

10. Zusammenbau, der eine Batterie bildet, mit einer Batterie, die eine positive und eine negative Klemme aufweist, mit einem Batterie-Abgangsgehäuse, das mindestens ein Funktionselement wie eine Sicherung und/oder einen Unterbrechungsschalter aufweist, mit einem Kabelschuh, der dazu bestimmt ist, mit einer Klemme der Batterie verbunden zu werden, und mit einem Mess-Shunt, **dadurch gekennzeichnet, dass** der Mess-Shunt und seine Elektronikschaltung für den Empfang, die Messung und die Verarbeitung des durch den Shunt fließenden Stroms in das Batterie-Abgangsgehäuse integriert sind, wobei die Elektronikschaltung für den Empfang, die Messung und die Verarbeitung einen Operationsverstärker aufweist, dessen zwei Eingänge e+ und e- mit den Klemmen des Mess-Shunts verbunden sind, wobei Einrichtungen vorgesehen sind, damit eine Gleichtaktspannung eines Werts, der dem Potential der positiven Klemme der Batterie entspricht, vom Verstärker angenommen wird.

11. Kraftfahrzeug, das einen Zusammenbau nach einem der vorhergehenden Ansprüche aufweist.
